(19) Europäisches Patentamt
European Patent Office
Office européen des brevets

(11) **EP 0 635 943 B1**

(12) **EUROPÄISCHE PATENTSCHRIFT**

(45) Veröffentlichungstag und Bekanntmachung des Hinweises auf die Patenterteilung:
**29.12.1997 Patentblatt 1997/52**

(51) Int Cl.⁶: **H03K 19/013**, H03K 19/086, H03K 3/2885

(21) Anmeldenummer: **94109988.9**

(22) Anmeldetag: **28.06.1994**

(54) **Ausgangsstufe für digitale Stromschalter**

Output stage for digital current switch

Etage de sortie pour commutateur de courant numérique

(84) Benannte Vertragsstaaten:
**DE DK FR GB IT SE**

(30) Priorität: **23.07.1993 DE 4324854**

(43) Veröffentlichungstag der Anmeldung:
**25.01.1995 Patentblatt 1995/04**

(73) Patentinhaber: **SIEMENS AKTIENGESELLSCHAFT**
**80333 München (DE)**

(72) Erfinder: **Delker, Klaus, Ing. grad.**
**D-81476 München (DE)**

(56) Entgegenhaltungen:
EP-A- 0 203 700          EP-A- 0 219 867
WO-A-85/02306          US-A- 4 943 741

• **PATENT ABSTRACTS OF JAPAN vol. 8 no. 13 (E-222) ,20.Januar 1984 & JP-A-58 177033 (MATSUSHITA DENKI SANGYO K.K.) 17.Oktober 1983,**

**Beschreibung**

Die Erfindung betrifft eine Ausgangsstufe mit den Merkmalen des Oberbegriffs von Patentanspruch 1.

Solche Ausgangsstufen sind aus dem Lehrbuch Tietze, Schenk: "Halbleiterschaltungstechnik", Seite 210, 9. Auflage, 1991 bekannt. Dort sind die Emitter der Emitterfolgertransistoren jeweils über einen Widerstand an das negative Versorgungspotential angeschlossen. Es ist weiterhin bekannt, anstelle der Widerstände Stromquellen zu verwenden.

Die Ausgangsanschlüsse der Ausgangsstufen sind im wesentlichen durch die daran angeschlossenen Verbindungsleitungen kapazitiv belastet. Bei einem Umschaltvorgang von L nach H fließen die Umladeströme der parasitären Kapazitäten jeweils über die Kollektor-Emitter-Strecken der Emitterfolgertransistoren. Bei einem Umschaltvorgang von H nach L fließen die Umladeströme über die Emitterstromzweige der Emitterfolgertransistoren. Der im Emitterstromzweig fließende Strom wird zwar nur beim letztgenannten Umschaltvorgang benötigt, fließt aber ständig. Dies hat eine hohe Verlustleistung zur Folge.

Aus der US-PS-4,943,741 ist eine Emitterfolger-Stromschalt-Schaltung für ECL/CML bekannt geworden. Dabei trennt die Emitterfolger-Stromschalt-Schaltung die Ausgangsstromsenke vom Gattereingang und einem entsprechenden Ausgangspuffer-Emitterfolger-Transistorelement, wenn sich der entsprechende Ausgang bei einem hohen Potential befindet. Eine Steuerschaltung steuert den Leitungszustand des Stromschalt-Transistorelements, so daß dieses leitend oder nicht-leitend bei entsprechenden Ausgangssignalen eines niedrigen bzw. hohen Potentials ist.

In ähnlicher Weise ist eine Logikschaltung konfiguriert, die in der EP-A-0 219 867 beschrieben ist. Auch dort ist der Ausgangsanschluß mit einer Stromquelle verbunden, wenn dieser auf einem niedrigen Pegel liegt.

Die Aufgabe der vorliegenden Erfindung ist es, eine Ausgangsstufe für digitale Stromscnalter mit einer geringen Verlustleistung bei gleicher Arbeitsgeschwindigkeit anzugeben.

Diese Aufgabe wird mit einer Ausgangsstufe mit den Merkmalen von Patentanspruch 1 gelöst.

Ausfünrungsformen und vorteilhafte Weiterbildungen und Verwendungen sind in den Unteransprüchen angegeben.

Die Erfindung wird im folgenden anhand der in den Figuren der Zeichnung dargestellten Ausführungsbeispiele näher erläutert. Es zeigen

Figur 1    eine erfindungsgemäße Ausgangsstufe,
Figur 2    eine vorteilhafte Weiterbildung der Ausgangsstufe und
Figur 3    Pegel- und Stromverläufe in der in der Figur 2 gezeigten Schaltung.

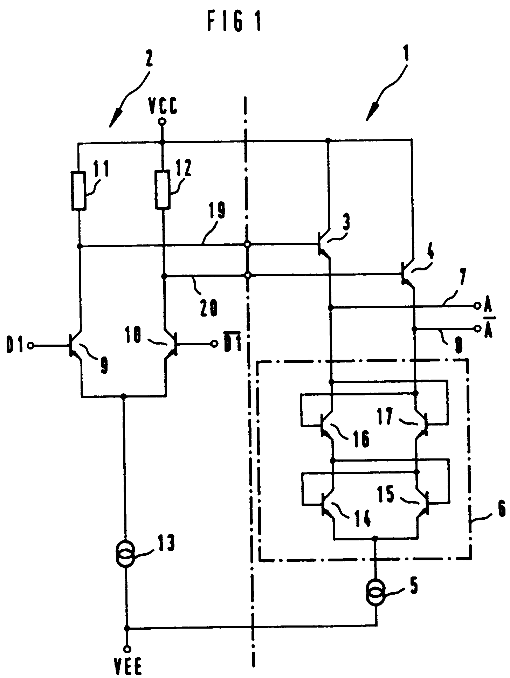

Die Ausgangstreiberstufe der Figur 1 enthält zwei als Emitterfolgertransistoren geschaltete Bipolartransistoren 3,4, deren Basisanschlüsse von komplementären Signalen gesteuert werden. Die Kollektoren der Transistoren 3, 4 sind an ein positives Versorgungspotential VCC angeschlossen. Die komplementären Signale werden von Ausgängen 19, 20 einer digitalen Stromschalterstufe 2 geliefert. Diese weist zwei emittergekoppelte Bipolartransistoren 9, 10 auf, deren Emitter über eine Stromquelle 13 an ein negatives Versorgungspotential VEE angeschlossen sind. In die Kollektorzweige der Transistoren 9, 10 ist je ein Widerstand 11 bzw. 12 geschaltet. Die Basisanschlüsse der Transistoren 9, 10 werden von komplementären Signalpegeln D1 bzw. $\overline{D1}$ gesteuert. Die kollektorseitigen Anschlüsse der Widerstände 11, 12 sind die Ausgänge des Stromschalters. Alternativ zu dem in der Figur 1 gezeigten Stromschalter mit zwei differentiellen Ausgängen, können auch zwei gleichartig aufgebaute Stromschalter verwendet werden, bei denen nur jeweils ein Ausgang mit dem Basisanschluß eines der Transistoren 3 bzw. 4 verbunden ist und deren entsprechende Eingangstransistoren von komplementären Datensignalen gesteuert werden.

Die Emitter der Bipolartransistoren 3, 4 sind mit je einem Ausgangssignalanschluß 7 bzw. 8 verbunden, die die komplementären Ausgangssignale A bzw. $\overline{A}$ führen. Die Emitter der Transistoren 3, 4 werden von einer Stromquelle 5 mit Strom versorgt. Ein erster Anschluß der Stromquelle 5 ist an das Versorgungspotential VEE angeschlossen, ein zweiter Anschluß ist über eine Umschalteinrichtung 6 mit den Emittern der Bipolartransistoren 3, 4 verbunden. Die Umschalteinrichtung 6 ist so eingestellt, daß durch sie die Stromquelle mit jeweils einem der Emitter der Bipolartransistoren 3, 4 verbunden wird.

Die Umschalteinrichtung 6 stellt sich derart ein, daß die Stromquelle 5 mit dem Emitter jeweils desjenigen der Bipolartransistoren 3, 4 verbunden ist, dessen Emitter einen H-Pegel führt. Wenn bei einem Umschaltvorgang der Pegel dieses einen Transistors von H nach L umschaltet, steht der Strom der Stromquelle 5 am entsprechenden Ausgangsanschluß 7 bzw. 8 zur Verfügung, um die mit diesem Ausgang verbundenen parasitären Kapazitäten umzuladen. Nach Beendigung des Umschaltvorgangs ist die Umschalteinrichtung 6 derart eingestellt, daß sie mit dem jeweiligen anderen der Bipolartransistoren 3, 4 verbunden ist, dessen Emitter nunmehr den H-Pegel führt. Somit ist nur eine Stromquelle notwendig, deren Strom mittels der Umschalteinrichtung 6 auf denjenigen Ausgang der Ausgangsstufe geschaltet wird, bei dem für den nächsten Umschaltvorgang der Strom für das Umladen der parasititären Kapazität benötigt wird.

Hierzu ist in der Umschalteinrichtung 6 ein Stromschalter aus zwei Bipolartransistoren 14, 15 vorgesehen, deren Emitter gekoppelt und mit der Stromquelle 5 verbunden sind. Die Basis jeweils eines der Transistoren 14, 15 ist mit dem Kollektor des anderen der Transistoren 14, 15 über Kreuz verbunden. Der Kollektor des Transistors 14 ist über die Kollektor-Emitter-Strecke eines Bipolartransistors 16 mit dem Emitter des Bipolartransistors 3 verbunden, der Kollektor des Transistors 15 über die Kollektor-Emitter-Strecke eines Bipolartransistors 17 mit dem Emitter des Bipolartransistors 4. Dabei sind die Basisanschlüsse der Transistoren 16, 17 jeweils über Kreuz mit ihren Kollektoren verbunden.

Die Transistoren 16, 17 wirken als Emitterfolgertransistoren bezüglich der an den Emittern der Bipolartransistoren 4 bzw. 3 anliegenden Signale. Die an den Emittern der Transistoren 16, 17 anliegenden Signale dienen der Umschaltsteuerung der Transistoren 15 bzw. 14 des Stromschalters. Folglich werden die Transistoren 14, 15 von den an den Emittern der Transistoren 3 bzw. 4 anliegenden Signalen gesteuert, wobei diese durch die Transistoren 17 bzw. 16 um je eine Basis-Emitter-Spannung zum Versorgungspotential VEE hin verschoben sind. Dies hat zur Folge, daß der Transistor 14 dann leitend gesteuert ist, wenn am Emitter des Transistors 3 ein H-Pegel anliegt. Der Transistor 15 ist hierbei gesperrt. Wenn am Emitter des Bipolartransistors 4 ein H-Pegel anliegt, ist der Transistor 15 leitend, der Transistor 14 gesperrt. Durch die Transistoren 14, ... , 17 der Umschalteinricntung 6 wird also der Strom der Stromquelle 5 auf denjenigen der Ausgänge 7, 8 geschaltet, der den H-Pegel führt.

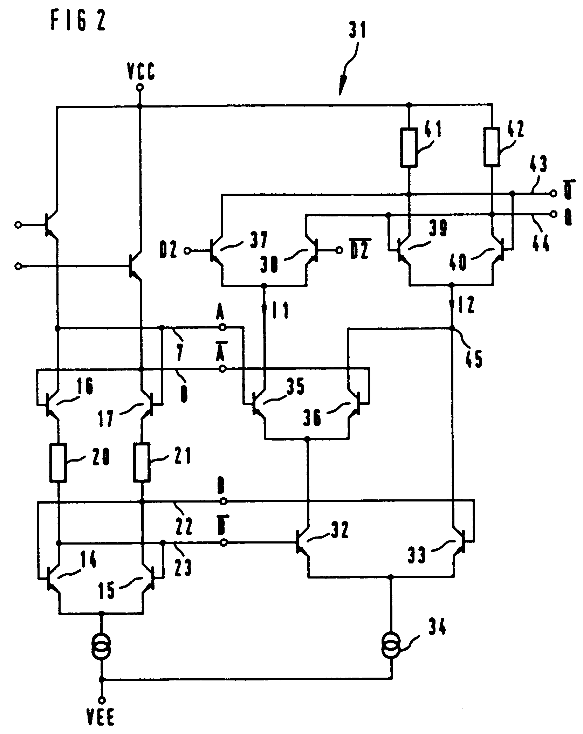

Die in der Figur 2 gezeigte Ausgangsstufe weist im Unterschied zur Ausgangsstufe der Figur 1 zusätzliche Widerstände 20, 21 auf, die zwischen dem Emitter des Transistors 16 und dem Kollektor des Transistors 14 bzw. dem Emitter des Transistors 17 und dem Kollektor des Transistors 15 geschaltet sind. Die Kollektoren der Transistoren 14, 15 dienen als weitere Schaltungsausgänge 23 bzw. 22, die die komplementären Signale $\overline{B}$, B führen. Die Signale B, $\overline{B}$ sind bezüglich der Signale A bzw. $\overline{A}$ zeitverzögert und jeweils um eine Basis-Emitter-Spannung verschoben. Die Widerstände 20, 21 wirken zusammen mit den an den Anschlüssen 7, 8, 22, 23 anliegenden kapazitiven Lasten als Zeitglieder. Der Wert der Zeitverscniebung zwischen den Signalen A, $\overline{A}$ und B, $\overline{B}$ kann deshalb über den Widerstandswert der Widerstände 21 bzw. 20 eingestellt werden.

Die in der Figur 2 gezeigte Ausgangsstufe eignet sich besonders zur Taktsignalansteuerung eines in Stromschaltertechnik realisierten Speicherelementes 31. Dabei wird das Speicherelement 31 mit den differenziellen Taktsignalen A, $\overline{A}$ und B, $\overline{B}$ angesteuert, wobei zwischen den Signalen A, $\overline{B}$ bzw. $\overline{A}$, B jeweils eine UND-Verknüpfung gebildet wird.

Das Speicherelement 31 weist hierzu zwei emittergekoppelte Transistoren 32, 33 auf, deren Emitter über eine Stromquelle 34 an das Versorgungspotential VEE angeschlossen sind. Die Basis des Transistors 32 ist mit dem Ausgang 23 der Ausgangsstufe verbunden, die Basis des Transistors 33 mit dem Ausgang 22. Der Transistor 32 wird also vom Signal $\overline{B}$ gesteuert, der Transistor 33 vom Signal B. Mit dem Kollektor des Transistors 32 sind die gekoppelten Emitter zweier weiterer Transistoren 35, 36 verbunden. Der Transistor 35 wird vom Signal A gesteuert, der Transistor 36 vom Signal $\overline{A}$. Die Kollektoren der Transistoren 33, 36 sind miteinander an einem Knoten 45 verbunden. Der Kollektor des Transistors 35 ist mit den gekoppelten Emittern zweier Bipolartransistoren 37, 38 verbunden, der Knoten 45 mit den gekoppelten Emittern zweier Bipolartransistoren 39, 40. Die Kollektoren der Transistoren 37, 38 und 39, 40 sind paarweise miteinander verbunden und über je einen Widerstand 41, 42 an das Versorgungspotential VCC angeschlossen. Der kollektorseitigen Anschlüsse der Widerstände 41, 42 sind mit Ausgangsanschlüssen 43 bzw. 44 des Speicherelementes verbunden. Die Basisanschlüsse der Transistoren 37, 38 werden von komplementären Signalen D2 bzw. $\overline{D2}$ gesteuert, die Basisanschlüsse der Transistoren 39, 40 sind auf die Ausgänge 44 bzw. 43 rückgekoppelt. Der Ausgang 44 führt das zum Signal D2 gleichsinnige Ausgangssignal Q, der Ausgang 43 das komplementäre Ausgangssignal $\overline{Q}$.

Wenn das Transistorpaar der Transistoren 37, 38 vom Strom der Stromquelle 34 durchflossen wird, stellen sich an den Ausgängen 43, 44 die Ausgangssignalpegel Q, $\overline{Q}$ gemäß den Eingangssignalen D2, $\overline{D2}$ ein. Schaltet der Strom der Stromquelle 34 auf das Transistorpaar der Transistoren 39, 40 um, wird durch die Rückkopplung der Zustand der Ausgangssignale in den Transistoren 39, 40 übernommen und gespeichert. Änderungen der Werte der Eingangssignale D2, $\overline{D2}$ bleiben dann auf die Ausgangssignale Q, $\overline{Q}$ ohne Einfluß.

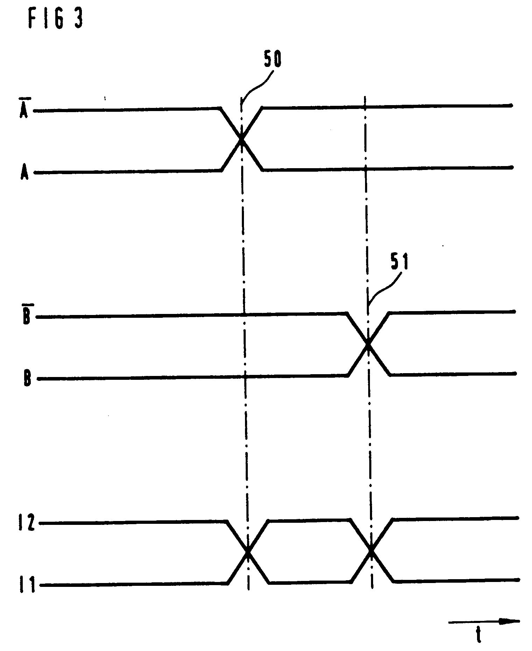

Durch den Kollektor des Transistors 35 fließt nur dann ein Strom, wenn die Signale A und $\overline{B}$ einen H-Pegel aufweisen. Anderenfalls fließt der Strom durch den Knoten 45. Der zeitliche Verlauf der Ströme I1, I2, die durch das Eingangs- bzw. Ausgangstransistorpaar fließen, sind im Zusammenhang mit den Signalen A, $\overline{A}$ und B, $\overline{B}$ in der Figur 3 dargestellt. Es ist erkennbar, daß der Umschaltzeitpunkt 51 der Signale B, $\overline{B}$ zeitverzögert zum Umschaltzeitpunkt 50 der Signale A, $\overline{A}$ liegt. Nur während der Zeitspanne zwischen den Schaltpunkten 50, 51 ist die Bedingung erfüllt, daß die Signale A, $\overline{B}$ beide gleichzeitig einen H-Pegel aufweisen. Deshalb fließt während dieser Zeit der Strom I1, anderenfalls der Strom I2. Zwischen den Zeitpunkten 50, 51 also die Ausgangssignale Q, $\overline{Q}$ auf die Eingangssignale D2, $\overline{D2}$ eingestellt, zum Zeitpunkt 51 wird durch das Umscnalten des Stromes von I1 auf I2 der Schaltzustand gespeichert. Ein solches Speicherelement weist eine einem taktflankengesteuerten Flip-Flop gleiche Scnaltcharakteristik auf, wenn die Zeit zwischen den Zeitpunkten 50, 51 als Setzzeit des Flip Flops aufgefaßt wird.

**Patentansprüche**

1. Ausgangsstufe mit den Merkmalen:

(a) die Basisanschlüsse eines ersten und eines zweiten Emitterfolgertransistors (3, 4) werden von komplementären digitalen Signalen gesteuert,

(b) die Kollektoren des ersten und zweiten Emitterfolgertransistors (3, 4) sind ein Anschluß für ein erstes Versorgungspotential (VCC),

(c) die Emitter des ersten und zweiten Emitterfolgertransistors (3, 4) sind mit je einem Ausgangssignalanschluß (7, 8) verbunden,

(d) die Emitter des ersten und zweiten Emitterfolgertransistors (3, 4) sind über eine Umschalteinrichtung (6) mit einem ersten Anschluß einer Stromquelle (5) verbunden,

(e) der zweite Anschluß der Stromquelle (5) ist ein Anschluß für ein zweites Versorgungspotential (VEE),

dadurch gekennzeichnet,

(f) daß durch die Umschalteinrichtung (6) der erste Anschluß der Stromquelle (5) mit dem Emitter desjenigen Emitterfolgertransistors (3 bzw. 4) verbunden ist, dessen Emitter jeweils das höhere Potential aufweist.

2. Ausgangsstufe nach Anspruch 1, **dadurch gekennzeichnet**, daß die Umschalteinrichtung (6) einen ersten und einen zweiten Bipolartransistor (14, 15) enthält, deren Emitter gekoppelt sind, daß die Emitter des ersten und zweiten Bipolartransistors (14, 15) mit dem ersten Anschluß der Stromquelle (5) verbunden sind, daß der Kollektor des ersten Bipolartransistors (14) über die Kollektor-Emitter-Strecke eines dritten Bipolartransistors (16) mit dem Emitter des ersten Emitterfolgertransistors (3) verbunden ist, daß der Kollektor des zweiten Bipolartransistors (15) über die Kollektor-Emitter-Strecke eines vierten Bipolartransistors (17) mit dem Emitter des zweiten Emitterfolgertransistors (4) verbunden ist, daß die Basis des ersten Bipolartransistors (14) mit dem Kollektor des zweiten Bipolartransistors (15) verbunden ist und die Basis des zweiten Bipolartransistors (15) mit dem Kollektor des ersten Bipolartransistors (14), und daß die Basis des dritten Bipolartransistors (16) mit dem Kollektor des vierten Bipolartransistors (17) verbunden ist und die Basis des vierten Bipolartransistors (17) mit dem Kollektor des dritten Bipolartransistors (16).

3. Ausgangsstufe nach Anspruch 2, **dadurch gekennzeichnet**, daß zwischen dem Emitter des dritten Bipolartransistors (16) und dem Kollektor des ersten Bipolartransistors (14) und zwischen dem Emitter des vierten Bipolartransistors (17) und dem Kollektor zweiten Bipolartransistors (15) je ein Widerstand (20 bzw. 21) geschaltet ist und daß die Kollektoren der ersten und zweiten Bipolartransistoren (14, 15) mit je einem weiteren Ausgangssignalanschluß (22 bzw. 23) verbunden sind.

4. Ausgangsstufe nach einem der Ansprüche 1 bis 3, **dadurch gekennzeichnet**, daß die Arbeitswiderstände (11, 12) je eines Zweiges eines als digitale Schaltstufe dienenden Differenzverstärkers mit den Basisanschlüssen der Emitterfolgertransistoren (3, 4) verbunden sind.

5. Verwendung einer Ausgangsstufe nach Anspruch 3 zur Taktansteuerung eines Speicherelementes, bei dem die an den gleichen Strompfad der Umschalteinrichtung (6) angeschlossenen Ausgangssignalanschlüsse (7, 23; 8, 22) zu einer logischen UND-Verknüpfung verbunden werden.

**Claims**

1. Output stage having the features:

(a) the base terminals of a first and of a second emitter follower transistor (3, 4) are controlled by complementary digital signals,

(b) the collectors of the first and second emitter follower transistors (3, 4) are a terminal for a first supply potential (VCC),

(c) the emitters of the first and second emitter follower transistors (3, 4) are connected to a respective output signal terminal (7, 8),

(d) the emitters of the first and second emitter follower transistors (3, 4) are connected via a changeover device (6) to a first terminal of a current source (5),

(e) the second terminal of the current source (5) is a terminal for a second supply potential (VEE),

characterized

(f) in that the changeover device (6) connects the first terminal of the current source (5) to the emitter of that emitter follower transistor (3 or 4) whose emitter has the higher potential in each case.

2. Output stage according to Claim 1, characterized in that the changeover device (6) contains a first and a second bipolar transistor (14, 15), the emitters of which transistors are coupled, in that the emitters of the first and second bipolar transistors (14, 15) are connected to the first terminal of the current source (5), in that the collector of the first bipolar transistor (14) is connected via the collector-emitter path of a third bipolar transistor (16) to the emitter of the first emitter follower transistor (3), in that the collector of the second bipolar transistor (15) is connected via the collector-emitter path of a fourth bipolar transistor (17) to the emitter of the second emitter follower transistor (4), in that the base of the first bipolar transistor (14) is connected to the collector of the second bipolar transistor (15), and the base of the second bipolar transistor (15) is connected to the collector of the first bipolar transistor (14), and in that the base of the third bipolar transistor (16) is connected to the collector of the fourth bipolar transistor (17), and the base of the fourth bipolar transistor (17) is connected to the collector of the third bipolar transistor (16).

3. Output stage according to Claim 2, characterized in that a respective resistor (20 and 21) is connected between the emitter of the third bipolar transistor (16) and the collector of the first bipolar transistor (14) and between the emitter of the fourth bipolar transistor (17) and the collector of the second bipolar transistor (15), and in that the collectors of the first and second bipolar transistors (14, 15) are connected to a respective further output signal terminal (22 and 23).

4. Output stage according to one of Claims 1 to 3, characterized in that the load resistors (11, 12) of each path of a differential amplifier serving as digital switching stage are connected to the base terminals of the emitter follower transistors (3, 4).

5. Use of an output stage according to Claim 3 for clock signal triggering of a storage element, in which the output signal terminals (7, 23; 8, 22) which are connected to the same current path of the changeover device (6) are connected to form a logic AND function.

**Revendications**

1. Etage de sortie présentant les caractéristiques suivantes :

(a) les bornes de bases d'un premier et d'un second transistors émetteurs-suiveurs (3, 4) sont commandées par des signaux numériques complémentaires,
(b) les collecteurs du premier et du second transistors émetteurs-suiveurs (3, 4) sont une borne pour un premier potentiel d'alimentation (VCC),
(c) les émetteurs du premier et du second transistors émetteurs-suiveurs (3, 4) sont reliés chacun à une borne de signal de sortie respective (7, 8),
(d) les émetteurs du premier et du second transistors émetteurs-suiveurs (3, 4) sont reliés à une première borne d'une source de courant (5) par le biais d'un circuit commutateur (6),

(e) la seconde borne de la source de courant (5) est une borne pour un second potentiel d'alimentation (VEE),

caractérisé en ce que
(f) la première borne de la source de courant (5) est reliée, à travers le circuit commutateur (6), à l'émetteur du transistor émetteur-suiveur (3 resp. 4) dont l'émetteur présente, à chaque fois, le potentiel le plus élevé.

2. Etage de sortie selon la revendication 1, caractérisé en ce que le circuit commutateur (6) comprend un premier et un second transistors bipolaires (14, 15) dont les émetteurs sont couplés, en ce que les émetteurs du premier et du second transistors bipolaires (14, 15) sont reliés à la première borne de la source de courant (5), en ce que le collecteur du premier transistor bipolaire (14) est relié à l'émetteur du premier transistor émetteur-suiveur (3) par le biais du trajet collecteur-émetteur d'un troisième transistor bipolaire (16), en ce que le collecteur du second transistor bipolaire (15) est relié à l'émetteur du second transistor émetteur-suiveur (4) par le biais du trajet collecteur-émetteur d'un quatrième transistor bipolaire (17), en ce que la base du premier transistor bipolaire (14) est reliée au collecteur du second transistor bipolaire (15) et la base du second transistor bipolaire (15) est reliée au collecteur du premier transistor bipolaire (14), et en ce que la base du troisième transistor bipolaire (16) est reliée au collecteur du quatrième transistor bipolaire (17) et la base du quatrième transistor bipolaire (17) est reliée au collecteur du troisième transistor bipolaire (16).

3. Etage de sortie selon la revendication 2, caractérisé en ce que, entre l'émetteur du troisième transistor bipolaire (16) et le collecteur du premier transistor bipolaire (14) et entre l'émetteur du quatrième transistor bipolaire (17) et le collecteur du second transistor bipolaire (15) est branchée, à chaque fois, une résistance (20 resp. 21), et en ce que les collecteurs des premier et second transistors bipolaires (14, 15) sont reliés, à chaque fois, à une borne de signal de sortie supplémentaire (22 resp. 23).

4. Etage de sortie selon l'une des revendications 1 à 3, caractérisé en ce que les résistances de charge (11, 12) de chaque branche d'un amplificateur différentiel servant d'étage de commutation numérique sont reliées aux bornes des bases des transistors émetteurs-suiveurs (3, 4).

5. Utilisation d'un étage de sortie selon la revendication 3 pour la commande par flancs d'horloge d'un élément de mémoire, dans lequel les bornes de signaux de sortie (7, 23; 8, 22) branchées sur le même trajet de courant du circuit commutateur (6) sont reliées de manière à obtenir une opération logique ET.

# FIG 1

FIG 2

FIG 3